# EUROPEAN PATENT APPLICATION

(11) **EP 1 388 900 A1**
(43) Date of publication of application: **11.02.2004**
(21) Application number: 02769570.9
(22) Date of filing: 13.05.2002
(51) Int. Cl.: H01L 43/08, G01R 33/09, G11B 5/39, H01F 10/32

(54) **MAGNETORESISTIVE ELEMENT**

(30) Priority: 15.05.2001 JP 2001144386
(71) Applicant: Matsushita Electric Industrial Co., Ltd., Kadoma-shi, Osaka-fu, 571-8501 (JP)
(72) Inventor: HIRAMOTO, Masayoshi, Ikoma-shi, Nara 630-0243 (JP); MATSUKAWA, Nozomu, Nara-shi, Nara 631-0015 (JP); ODAGAWA, Akihiro, Nara-shi, Nara 631-0032 (JP); IIJIMA, Kenji, Kyoto-shi, Kyoto 612-8081 (JP); SAKAKIMA, Hiroshi, Kyotanabe-shi, Kyoto 610-0352 (JP)
(74) Representative: Tothill, John Paul
(86) International application number: PCT/JP2002/004589
(87) International publication number: WO 2002/093661

(57) **Abstract**

The present invention provides a tunnel magnetoresistive (TMR) element that increases a MR ratio and suppresses the unevenness in resistance. In an embodiment of the present invention; a surface property-controlling layer is arranged between the substrate and the tunnel layer. In another embodiment, at least one of the magnetic layers sandwiching the tunnel layer has an oriented crystal plane other than the closest packed plane. In still another embodiment, the at least one of the magnetic layers includes a magnetic element and a non-magnetic element and has an average electron number of 23.5 to 25.5 or 26.5 to 36. In still another embodiment, the TMR element includes an excess-element capturing layer. This layer includes an alloy or a compound that contains the excess element. The content of the excess element in the capturing layer is higher than those in the magnetic layers.

## Description

### TECHNICAL FIELD

The present invention relates to a magnetoresistive element. This magnetoresistive element can be used for a magnetic head for a magnetic disk, a magneto-optical disk, and a magnetic tape; a magnetic sensor used in automobiles and the like; and a magnetic random access memory (MRAM), for example.

### BACKGROUND ART

In resent years, various researches has been conducted with respect to a tunnel magnetoresistance (TMR) element. In a TMR element, a tunnel transition probability changes with a relative angle formed by magnetization directions of the two magnetic layers that sandwich a tunnel non-magnetic layer (tunnel insulating layer). The larger spin polarization near the Fermi-surface the magnetic layer has, the greater MR change the TMR element can provide. FeCo alloy, NiFe alloy and a half-metallic ferromagnetic material are known as metallic magnetic materials that may generate a larger spin polarization.

However, so far, no materials have been found that would be superior to the metallic magnetic materials in MR characteristics.

Further, when the sizes of TMR elements decrease to sub-micron dimensions, grain boundaries on a polycrystalline substrate and crystal growth in a thick electrode significantly affect the thickness and quality of the tunnel layer, which causes unevenness in conjunction resistance of the element.

### DISCLOSURE OF THE INVENTION

It is an object of the present invention to provide a TMR element that can provide a higher MR ratio. It is another object of the present invention to suppress the unevenness in conjunction resistance of TMR elements.

According to the present invention, a first embodiment of the magnetoresistive element includes a substrate and a multi-layer film formed on the substrate, and the multi-layer film includes a tunnel layer and a pair of magnetic layers that sandwich the tunnel layer. A resistance value changes with a relative angle formed by the magnetization directions of the pair of magnetic layers. In this magnetoresistive element, a conductive layer is arranged between the substrate and the tunnel layer, and the conductive layer is at least one selected from:
a) a conductor composed of at least one selected from Pt, Pd, Ag, Au, C, Si, Ge, Sn and Pb;
b) an amorphous film;
c) a microcrystalline film having an average crystal diameter of 5 nm or less; and
d) a laminate including a Cu film and a non-Cu metal film.
   According to the present invention, a second embodiment of the magnetoresistive element includes a substrate and a multi-layer film formed on the substrate, and the multi-layer film includes a tunnel layer and a pair of magnetic layers that sandwich the tunnel layer. A resistance value changes with a relative angle formed by the magnetization directions of the pair of magnetic layers. In this magnetoresistive element, at least one layer selected from the pair of magnetic layers includes at least one selected from:
e) a lattice strain expressed by a lattice constant difference in a range of 0.1% to 5% with respect to a lattice constant that is calculated from the crystal structure of said at least one layer;
f) a crystal structure that is different from a preferential crystal structure at the ordinary temperature and the atmospheric pressure; and
g) a polycrystalline structure having an oriented crystal plane controlled to be other than the closest packed plane of the crystal structure of said at least one layer.

According to the present invention, a third embodiment of the magnetoresistive element includes a substrate and a multi-layer film formed on the substrate, and the multi-layer film includes a tunnel layer and a pair of magnetic layers that sandwich the tunnel layer. A resistance value changes with a relative angle formed by the magnetization directions of the pair of magnetic layers. In this magnetoresistive element, at least one layer selected from the pair of magnetic layers includes at least one element selected from Fe, Co and Ni, and an element other than Fe, Co and Ni, and an average electron number of said at least one layer is in a range of 23.5 to 25.5 or 26.5 to 36, where the average electron number is a per-atom electron number calculated on the basis of the composition ratio of said at least one layer. In other words, the average electron number can be determined by calculating an average of the atomic numbers (electron numbers) of the atoms in the layer.

According to the present invention, a fourth embodiment of the magnetoresistive element includes a substrate and a multi-layer film formed on the substrate, and the multi-layer film includes a tunnel layer and a pair of magnetic layers that sandwich the tunnel layer. A resistance value changes with a relative angle formed by magnetization directions of the pair of magnetic layers. In this magnetoresistive element, at least one layer selected from the layers in the multi-layer film that is other than the pair of magnetic layers includes an excess element, and this additional element decreases spin polarization in at least one magnetic layer selected from the magnetic layers when the concentration of the excess element in said at least one magnetic layer increases. The multi-layer film further includes an excess-element capturing layer including an alloy or a compound that contains the excess element, and the content of the excess element in the excess-element capturing layer is higher than those in the magnetic layers.

### BRIEF DESCRIPTION OF THE DRAWINGS

Fig. 1 is a cross-sectional view showing a basic configuration of a magnetoresistive element of the present invention.
Fig. 2 is a cross-sectional view showing a configuration in which a control layer is added to the basic configuration in Fig. 1.

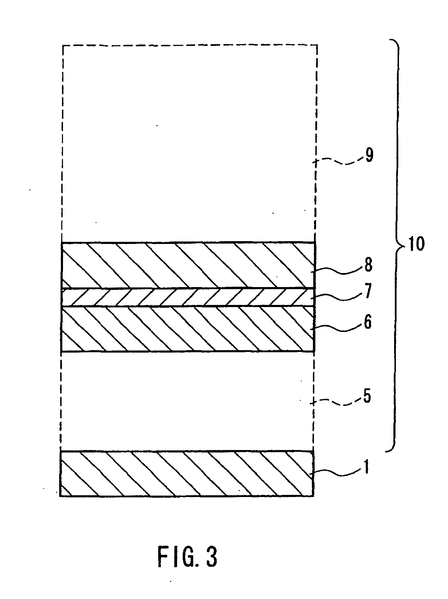

Fig. 3 is a cross-sectional view for describing a preferable position of a control layer.
Fig. 4 is a cross-sectional view for describing a preferable position of an excess-element capturing layer.
Fig. 5 is a cross-sectional view showing an embodiment of a magnetoresistive element of the present invention.
Fig. 6 is a cross-sectional view showing another embodiment of a magnetoresistive element of the present invention.

### EMBODIMENTS OF THE INVENTION

Hereinafter preferred embodiments of the present invention will be described.

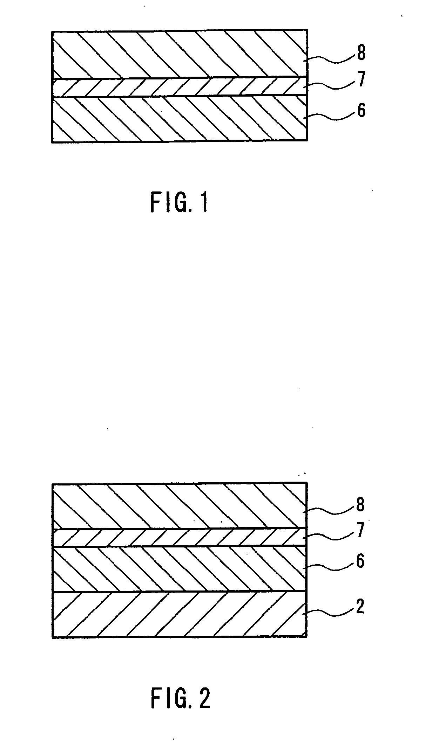

As illustrated in Fig. 1, a magnetoresistive element of the present invention includes a basic laminate that has a tunnel layer 7 and a pair of magnetic layers 6, 8 sandwiching the tunnel layer. The tunnel layer 7 can be composed of an insulator such as a nitride, an oxide, a carbide and a boride, or a semiconductor. The magnetic layers 6, 8 should be composed of a ferromagnetic material or a ferrimagnetic material.

The magnetoresistive element can be a so-called spin-valve type element. In this element, one magnetic layer is a pinned layer in which the magnetization is relatively harder to rotate with an external magnetic field. The other magnetic layer is a free magnetic layer in which the magnetization can be relatively easier to rotate. The pinned layer can be magnetically connected to a magnetization rotation-suppressing layer such as an antiferromagnetic layer and a laminated ferrimagnetic layer while the free layer can be magnetically connected to a soft magnetic layer.

### Embodiment 1

First, the first element of the present invention will be described.

In this element, a conductive layer (a surface property-controlling layer) that corresponds to at least one of the above a) to d) is formed between the substrate and the tunnel layer.

A layer of a) that is composed of the predetermined element(s) works as a "surfactant" layer to improve the surface evenness of the tunnel layer. A layer of b) or c) that is amorphous or microcrystalline works to suppress the roughness of films on this layer and pinholes in the tunnel layer. A laminate of d) also can improve the roughness of films on this laminate. Thus, the surface property-controlling layer decreases the unevenness in tunneling resistance and a coercive force caused by an orange-peel coupling, especially when the tunnel layer is designed in sub-micron dimensions.

When the surface property-controlling layer is at least one of a), b) and c), the thickness of the surface property-controlling layer is preferably 10 nm or less. This preferable range can help decreasing the effect of a demagnetizing field to the element designed in sub-micron dimensions. The thickness of the surface property-controlling layer is preferably 0.5 nm or more, because the roughness can be suppressed better.

The surface property-controlling layer should be a magnetic layer (magnetic conductive layer) or a non-magnetic layer (non-magnetic conductive layer). The conductive layer of a) is non-magnetic while the microcrystalline layer of c) is preferably magnetic.

A magnetic conductive layer of b) or c) is easy to obtain from a magnetic material that includes: at least one selected from Fe, Co and Ni as a main component; at least one element selected from Al, Si, Ga, Ge, Group IIa (Group 2 in the latest IUPAC system) elements and Group VIa (Group 6) elements; and at least one element selected from B, C, N, O and P. A preferable content of the at least one element selected from B, C, N, O and P is in a range of 10 to 30 at%. Here, "a main component" denotes a component that occupies the highest content.

In a layer of d), a metal film having a lattice constant that differs from that of a Cu film by 10% or more is suitable for the metal film to be laminated with the Cu film. A metal film having a crystal structure that differs from that of a Cu film also is suitable for the metal film to be laminated. The thickness of the Cu film is preferably in a range of 2 nm to 100 nm. The thickness of the non-Cu metal film is preferably in a range of 0.3 nm to 5 nm. The total thickness of the laminate is preferably in a range of 50 nm to 5 µm. This laminate can be used for a lower electrode or a part of the lower electrode.

A magnetic surface property-controlling layer may be a part of the magnetic layer in the magnetoresistive element. In this case, the magnetic layer (6 in Fig. 1) arranged on the substrate-side (downward in Fig. 1) includes the surface property-controlling layer.

In a usual case, the magnetic layer is a layer that does not correspond to any of a) to d). However, the magnetic layer can serve as a surface property-controlling layer. Even in the case that the magnetic layer and the surface property-controlling layer are arranged separately, the magnetic layer may be either one selected from a magnetic amorphous layer and a magnetic microcrystal layer that has an average crystal diameter of 5 nm or less. In this case, the unevenness in conjunction resistance can be suppressed more sufficiently while a MR ratio might be decreased.

In Fig. 2, a surface property-controlling layer 2 and a magnetic layer 6 are arranged separately. The surface property-controlling layer 2 need not contact the magnetic layer 6 and should be involved in a position 5 between the substrate 1 and the magnetic layer 6 not in the opposite-side position 9 with respect to the tunnel layer 7 in a multi-layer film 10. A magnetic surface property-controlling layer can be a high coercive magnetic film or a soft magnetic film that are magnetically connected to the magnetic layer 6 arranged on the substrate side.

A TMR element in this embodiment easily can provide a stable conjunction resistance even if the substrate is a polycrystal that inherently has many pinholes and a relatively rough surface.

### Embodiment 2

Next, the second element of the present invention will be described.

In this element, at least one selected from: e) a predetermined lattice strain; f) a crystal structure (crystal system) that is not preferentially formed at the ordinary temperature and the atmospheric pressure; and g) an oriented crystal plane other than the closest packed plane is introduced into at least one of the magnetic layers. Thus, the element can provide a higher MR ratio.

To introduce at least one of e), f) and g) into a magnetic layer, a crystal-structure controlling layer can be arranged in contact with the magnetic layer. As in Fig. 2, the crystal-structure controlling layer 2 should be formed such that the layer 2 contacts the magnetic layer 6 that should have the lattice strain or the like. Either of the magnetic layer and the crystal-controlling layer can be formed on the other layer by epitaxial growth.

When introducing the lattice strain, the crystal-structure controlling layer should be formed to cause a lattice mismatch with respect to the closest packed plane in the preferentially-formed crystal structure of the magnetic layer. When controlling the crystal system or the orientation of the crystal, the crystal-structure controlling layer should be formed to cause a relatively small lattice mismatch with respect to a crystal plane other than the closest packed plane.

It is believed that a suitable lattice strain of e) in the magnetic layer brings an increase of the spin polarization near the Fermi surface and an increase of the MR ratio.

The crystal-structure controlling layer for introducing the lattice strain may contain: the magnetic element(s) included in the magnetic layer that should have the lattice-strain, which is at least one of Fe, Co and Ni; and an element other than the magnetic element (Fe, Co and Ni), which is a non-magnetic element. When the magnetic layer is composed of magnetic element(s) M, a preferable composition of the crystal-controlling layer is M₁₋ₓAₓ, where A is at least one non-magnetic element, and 0<x<1.

A crystal structure f) that differs from the preferential crystal structure also can increase the MR ratio.

At the ordinary temperature and pressure, Fe preferentially has a bcc (body-centered cubic) lattice, Co preferentially has an hcp (hexagonal closest packing) lattice and Ni preferentially has an fcc (face-centered cubic) lattice. However, a magnetic layer including a metastable crystal structure such as fcc-Fe, bcc-Co or bcc-Ni can increase the MR ratio.

FeCo alloy having a composition that preferentially includes a bcc such as Fe₅₀Co₅₀ should be controlled to include an hcp or an fcc. FeCo alloy having a composition that preferentially includes an hcp or an fcc such as Fe₁₀Co₉₀ should be controlled to include a bcc. NiFe alloy having a composition that preferentially includes an fcc should be controlled to include a bcc.

It was found that a metastable crystal structure that occupies at least 30% with respect to the whole crystal of the magnetic layer sufficiently raises the MR ratio. The metastable crystal structure can increase the MR ratio also in a magnetic layer that includes a non-magnetic element in addition to a magnetic element.

In many cases, a metastable crystal structure involves a lattice strain. At the present, it is difficult to clearly separate the effect of the crystal structure shift from the effect of the lattice strain. However, in any case, it is believed that an increase of spin polarization caused by the shift of bands that accompanies the change of crystal structure contributes to the increase of the MR ratio.

A polycrystal g) having an oriented crystal plane that is controlled to be other than the closest packed plane also can increase the MR ratio.

In the magnetic layer, a MR ratio tends to rise when an observed component from a crystal plane other than the closest packed plane such as a (111) component in a bcc and a (100) or (110) component in an fcc increases. Specifically, the MR ratio increases when an X-ray diffraction chart indicates that the magnetic layer has an orientation of a crystal plane other than the closest packed plane.

A magnetic layer having at least f) and g) provides a still higher MR ratio. When e) also is introduced to the magnetic layer having f) and g), the MR ratio further increases.

It is preferable that the magnetic layer satisfying at least one of e), f) and g) has a thickness of 3 nm or less.

### Embodiment 3

Subsequently the third element of the present invention will be described.

In a magnetic alloy layer that is composed of magnetic elements (Fe, Co and Ni), the largest spin polarization can be achieved in a composition of around Fe₇₀Co₃₀. Fe₇₀Co₃₀ has an average electron number of 26.3 (26 (Atomic Number of Fe) × 0.7 + 27 (Atomic Number of Co) × 0.3 = 26.3). On the other hand, in a magnetic layer that includes at least one of the magnetic elements and at least one non-magnetic element, a larger spin polarization can be achieved when an average electron number of the magnetic layer is not less than 23.5 and not more than 25.5, or not less than 26.5 and not more than 36.

According to the Example described below, a more preferable average electron number is not less than 24.5 and not more than 25.5, or not less than 27.5 and not more than 32.5. It is preferable that this magnetic layer includes the at least one of the magnetic elements as a main component. In other words, the total amount of the magnetic elements is preferably larger than that of non-magnetic elements.

As far as the Inventors have confirmed, there are no limitations on the non-magnetic element to be used for the magnetic layer. A preferable non-magnetic element is, for example, at least one selected from Si, Al, Ti, V, Cr, Mn, Ru, Rh, Pd, Os, Ir, Pt, B, C, N and O.

### Embodiment 4

Lastly, the fourth element of the present invention will be described.

The element in this embodiment includes an excess-element capturing layer. An excess element decreases the spin polarization in a magnetic layer when the concentration of the excess element in the magnetic layer increases. The excess element is, for example, at least one selected from Mn, Ru, B, C, N and O. The excess element diffuses throughout the magnetoresistive element during a heat treatment in a manufacturing process for the magnetoresistive element, resulting in deterioration of the spin polarization.

It should be noted that the excess element in the magnetic layer could increase the MR ratio of the magnetoresistive element due to some factors other than the spin polarization.

The excess-element capturing layer preferably includes a metal that can form an alloy or a compound with an excess element before capturing, and includes an alloy or a compound containing an excess element after capturing the excess element.

At least one of B, C, N and O may be an excess element when the tunnel layer includes a boride, a carbide, a nitride and an oxide. In this case, it is preferable that the excess-element capturing layer includes a metal having a formation free-energy for a compound selected from an oxide, a nitride, a carbide and a boride that is lower than the formation free-energy for the compound of Fe. Examples of such an element include at least one selected from Al, Si, Group IVa (Group 4) elements, Group Va (Group 5) elements and Group VIa (Group 6) elements.

The magnetization rotation-suppressing layer in a spin-valve type element may supply an excess element. At least one selected from Mn and Ru is typical of the excess element in the layer. Mn may diffuse from an antiferromagnetic layer that includes Mn, and Ru may diffuse from a non-magnetic film that includes Ru. This non-magnetic film can be used in a laminated ferrimagnetic material (a laminate including: a magnetic film / Ru / a magnetic film). The laminated ferrimagnetic material can be used as the magnetic layer as well as a magnetization rotation-suppressing layer in the TMR element. To capture the excess element from a magnetization rotation-suppressing layer, it is preferable that the excess-element capturing layer includes at least one metal selected from Fe, Ni, Ir, Pd and Pt.

The excess element diffuses from an excess-element supplying layer such as a tunnel layer and a magnetization rotation-suppressing layer into other layers. A preferable relationship of the contents of the excess element in the layers after the diffusion can be expressed by Rs ≥ Rc > Rm, where Rs is a content of the excess element in the excess-element supplying layer, Rc is a content of the excess element in the excess-element capturing layer and Rm is a content of the excess element in the magnetic layer.

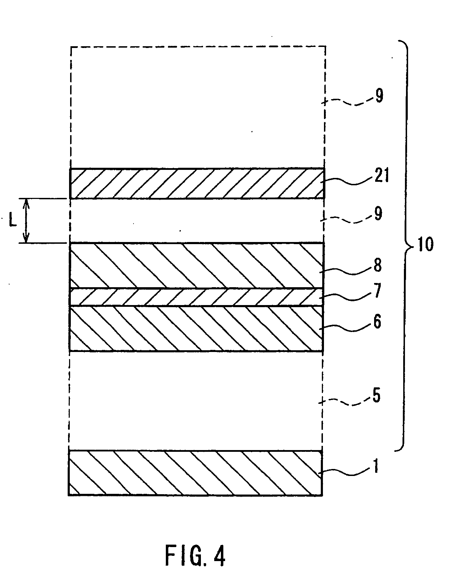

As illustrated in Fig. 4, the excess-element capturing layer 21 should be arranged such that the distance L between the excess-element capturing layer 21 and at least one selected from the pair of magnetic layers (e.g. magnetic layer 8 in Fig. 4) with respect to the thickness direction of the multi-layer film is 10 nm or less because this arrangement is effective in reducing the content of the excess-element in the magnetic layer.

The following is an additional explanation common to all the embodiments of the present invention.

At least one of the magnetic layers may include at least one selected from B, C, N, O and P in a range of 0.1 at% to 15 at%, because it is effective in introducing a lattice strain, controlling an orientation of a crystal plane, adjusting an average electron number or the like. At least one of the magnetic layers may include at least one selected from Mn and the Platinum Group elements in a range of 0.1 at% to 40 at%.

To form the films for the magnetoresistive element, various conventional film-forming methods such as vacuum deposition, ion beam deposition (IBD), sputtering, and ion plating can be used.

A tunnel layer can be formed by sputtering with a compound target, or by a reactive deposition method, a reactive sputtering method, an ion-assisting method, or the like. A chemical vapor deposition (CVD) method also can be used. A tunnel layer can be formed by having a metal film react in an atmosphere that contains a reactive gas at an appropriate partial pressure or in plasma.

To process the films into the magnetoresistive element, physical or chemical etching, such as ion milling, RIE, FIB, I/M and the like with photolithography techniques that are used in a semiconductor process can be used. When flattening the surfaces of the films is needed, CMP or cluster ion beam etching can be used.

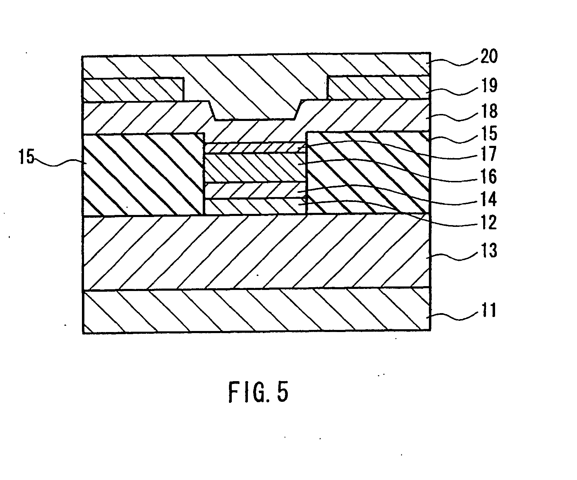

The magnetoresistive element of the present invention can be used for various magnetic devices. In Fig. 5, the magnetoresistive element is used in a magnetic head in which a free layer 18 works as a yoke. In this magnetic head, a lower electrode 13, a control layer 12, antiferromagnetic layer 14, a pinned magnetic layer 16, a tunnel layer 17, a free magnetic layer 18 and an upper electrode 20 are formed in this order on a substrate 11. The control layer 12 may be a surface property-controlling layer in the first embodiment or a crystal-structure controlling layer in the second embodiment.

The electrodes 13, 20 are arranged to sandwich the magnetic layer 16,18 and the tunnel layer 17. An interlayer insulating film 15 is arranged such that all the electric current between the electrodes 13, 20 passes through the tunnel layer 17. A hard magnetic film (or an antiferromagnetic film) 19 is added to this magnetic head.

### EXAMPLES

### Example 1

In this example, magnetoresistive elements according to the first embodiment are described.

A multi-layer film was formed on an AlTiC polycrystal substrate by a RF sputtering method and a resistance-heating vacuum deposition. The multi-layer film was as follows:
Ta(3) / Cu(500) / Surface Property-Controlling Layer(10) / PtMn(30) / CoFe(3) / Ru(0.7) / CoFe(3) /Al(0.4; 200Torr, pure oxygen, 1 min oxidization) / Al(0.3; 200Torr, pure oxygen, 1 min oxidization / CoFe(3) / NiFe(5) / Ta(3)

Here, the figures in parentheses denote the film thickness (in nm). Oxidization conditions for Al also are described in the parentheses. These are expressed in the same manner in the following.

After micro-processing the multi-layer film into a mesa structure, the Ta film was removed by milling and a film of NiFe (5) / CoPt (30) was formed. Next, the CoPt formed directly on the mesa structure was removed, followed by forming a film of Cu (500) as a top layer. Thus, the magnetoresistive element as shown in Fig. 5 was obtained.

Subsequently, to impart unidirectional anisotropy to the PtMn, the element was heat-treated at 280°C in a first magnetic field of 5 kOe (about 398 kA/m) and then heat-treated at 200°C in a second magnetic field of 100 Oe that is perpendicular to the first magnetic field.

Magnetoresistive elements were manufactured in a manner similar to the above method except that a laminate consisting of ten sub-laminates was substituted for the laminate of Cu (500) and a Surface Property-Controlling Layer (10). Here, each sub-laminate is a double-layered film of a Cu film (50) and a non-Cu film (0.5 or 2.5). Another magnetoresistive element was manufactured in a manner similar to the above method except that an Si substrate with a thermal-oxidation layer was substituted for the AlTiC substrate. Another magnetoresistive element that does not have a Surface Property-Controlling Layer also was manufactured for comparison.

A MR ratio, a coercive force and unevenness in conjunction resistance were examined for each of the magnetoresistive elements. To calculate the unevenness, the resistance values were measured at 30 points on a wafer having a diameter of 6 inches. The unevenness was expressed by the standard deviation σ of the values. Table 1 shows the result.

**Table 1-1**

| Substrate | Surface Property Controlling Layer | MR Ratio (%) | Hc (Oe) | Unevenness (%) |
|---|---|---|---|---|
| Si/SiO₂ | - | 26 | 10 | 5 |
| AlTiC | - | 15 | 50 | 55 |
| AlTiC | Au(500C°) | 25 | 10 | 5 |
| AlTiC | Au(r.t.) | 18 | 25 | 25 |
| AlTiC | Pd | 25 | 10 | 8 |
| AlTiC | Ag | 23 | 13 | 7 |
| AlTiC | Pt | 23 | 12 | 9 |
| AlTiC | Pb | 25 | 12 | 7 |
| AlTiC | Cr | 21 | 18 | 11 |
| AlTiC | Al | 20 | 28 | 19 |

**Table 1-2**

| Substrate | Surface Property Controlling Layer | MR Ratio (%) | Hc (Oe) | Unevenness (%) |
|---|---|---|---|---|
| AlTiC | TiSi | 24 | 11 | 7 |
| AlTiC | ZrAlNiCu | 25 | 10 | 6 |
| AlTiC | ZrNbAlCu | 23 | 12 | 8 |
| AlTiC | CuSiB | 24 | 11 | 6 |
| AlTiC | CoFeB | 24 | 11 | 7 |
| AlTiC | FeSiNb | 22 | 12 | 8 |
| AlTiC | Cu(50) / Pt(0.5) Laminate | 24 | 11 | 6 |
| AlTiC | Cu(50) / Cr(2.5) Laminate | 26 | 10 | 6 |
| Hc = Coercive Force | | | | |

The surface property-controlling layers of Au were formed at room temperature and one layer (500C°) was heat-treated at 500C° while the other (r.t.) was not heat-treated. The other surface property-controlling layers were not heat-treated after forming the layers. In the elements of a), Pt and Pd should not be heat-treated, Au should be heat-treated preferably at not less than 400C°, and the other elements may be formed with or without the heat-treatment.

TiSi, ZrAlNiCu, ZrNbAlCu and CuSiB were non-magnetic amorphous films, CoFeB was a magnetic amorphous film and FeSiNb was a microcrystal film that had an average crystal diameter of 5 nm or less.

Other experiments showed that a metal film having a difference in lattice constant by 10% or more with respect to that of a Cu film and a metal film having a crystal structure that differs from that of a Cu film were suitable for a film to be laminated with a Cu film. Furthermore, a metal having a solid solubility of 10% or less in Cu was more suitable for the metal film. Examples of the metal satisfying these conditions include Cr. Although Pt can make a solid solution with Cu in a phase diagram, Pt has a relatively low diffusion coefficient. Thus, Pt also was a suitable element.

Furthermore, magnetoresistive elements were manufactured in a manner similar to the above method except that a CoFeB film or an FeSiB film was substituted for the CoFe film that was arranged on the substrate-side. Although the substitutions decreased the MR ratio to 16% and 17%, respectively, the conjunction resistances of these elements were 5% and 6%, respectively. Both of the elements provided a coercive force of 10 Oe.

The observation with an Atomic Force Microscope (AFM) showed that a surface property-controlling layer suppressed the roughness of the multi-layer film.

### Example 2

### (Example 2-1)

In this example, magnetoresistive elements according to the second embodiment are described.

A multi-layer film was formed on an Si substrate with a thermal-oxidation layer by a RF sputtering method. The multi-layer film was as follows:
Ta(3) / Cu(500) / Ta(3) / Crystal-Structure Controlling Layer(10) / Fe(3) / Al(0.4; 200Torr, pure oxygen, 1 min oxidization) /Al(0.3; 200Torr, pure oxygen, 1 min oxidization / CoFe(3) / Ru(0.7) / CoFe(3) / PtMn(30) / Ta(3)

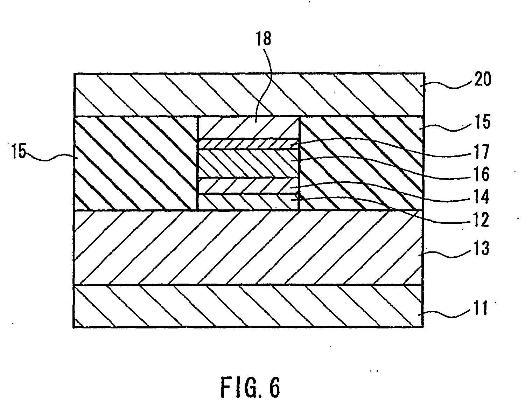

A magnetoresistive element as shown in Fig. 6 was manufactured in the same manner as Example 1. Reference numerals in Fig. 6 indicate the same in Fig. 5., respectively

As the crystal-structure controlling layer, (110) oriented Fe₁₋ₓSiₓ (0<x<1) was used. A lattice strain was introduced into the Fe film on the crystal-structure controlling layer by adjusting the content of Si. A MR ratio was examined on each of the magnetoresistive elements. Table 2 shows the result.

**Table 2**

| Increase in Lattice Constant (%) | MR Ratio (%) |
|---|---|
| 0 | 20 |
| 0.1 | 22 |
| 3.0 | 27 |
| 4.0 | 25 |
| 5.0 | 20 |
| 6.0 | 18 |

Here, the increase in lattice constant was calculated by the lattice constant of the Fe film that was determined by X-ray diffraction and RHEED (Reflection High Energy Electron Diffraction) and the lattice constant calculated on the crystal structure of the Fe film.

### (Example 2-2)

A multi-layer film was formed on a glass substrate by a RF sputtering method. The multi-layer film was as follows:
Ta(3) / Cu(500) / Ta(3) / Crystal-Structure Controlling Layer (10) / CoFe(3) / Al(0.4; 200Torr, pure oxygen, 1 min oxidization) /Al(0.3; 200Torr, pure oxygen, 1 min oxidization / CoFe(3) / Ru(0.7) / CoFe(3) / PtMn(30) / Ta(3)

A magnetoresistive element as shown in Fig. 6 was manufactured in the same manner in Example 1.

As the crystal-structure controlling layer, (110) oriented Fe₁₋ₓAlₓ (0<x<1) was used. A lattice strain was introduced into the CoFe film on the crystal-structure controlling layer by adjusting the content of Si. A MR ratio was examined on each of the magnetoresistive elements. Table 3 shows the result.

**Table 3**

| Increase in Lattice Constant (%) | MR Ratio (%) |
|---|---|
| 0 | 25 |
| 0.1 | 30 |
| 1.0 | 37 |
| 1.5 | 33 |

### (Example 2-3)

A multi-layer film was formed on a Cu single crystal substrate by a RF sputtering method. The multi-layer film was as follows:
Cu(500; Crystal-Structure Controlling Layer) / Fe(5ML) /Al(0.4; 200Torr, pure oxygen,1 min oxidization) /Al(0.3; 200Torr, pure oxygen, 1 min oxidization / CoFe(3) / Ru(0.7) / CoFe(3) / PtMn(30) / Ta(3)

Here, 5ML means a thickness of five unit cells. This Fe (5ML) film was polycrystalline.

A magnetoresistive element as shown in Fig. 6 was manufactured in the same manner in Example 1. In this magnetoresistive element, the substrate and the crystal-structure controlling layer worked also as a lower electrode. The crystal structure of the Fe film was changed by adjusting the orientation of the Cu single crystal.

Furthermore, magnetoresistive elements were manufactured in a manner similar to the above method except that an MgO single crystal or a Si substrate with a thermal-oxidation layer was substituted for the Cu single crystal substrate and a Pt film was substituted for the Cu film.

A MR ratio and an orientation ratio of the Fe film were examined. The orientation ratio was measured by the ratios among the peaks that were obtained by an X-ray diffraction method. The orientation ratio indicates the rate of an area in an interface of the crystal plane. Strictly describing, the value measured by an X-ray diffraction method does not exactly indicate the orientation ratio. However, in this example, the values by an X-ray diffraction method were correlated with the MR ratios. Table 4 shows the result.

**Table 4**

| Substrate and Crystal-Structure Controlling Layer with their Orientation | Fe Orientation Ratio (%) | MR Ratio (%) |
|---|---|---|
| Cu(100) / Cu(100) / fcc-Fe(100) | 97 - 99 | 30 |
| Cu(111) / Cu(111) / fcc-Fe(111) | 96 - 99 | 25 |
| Cu(110) / Cu(110) / bcc-Fe(110) | 97 - 99 | 18 |
| MgO(100) / Cu(100) / fcc-Fe(100) | 83 -87 | 29 |
| Si / SiO / Pt(111) / fcc-Fe(111) | 70 -76 | 24 |

The MR ratio increased when the Fe film had a crystal structure differing from bcc, a preferential structure of Fe at the ordinary temperature and the atmospheric pressure. A hcp-Fe film also provided a higher MR ratio than that in the bcc-Fe film. In the fcc-Fe films, the films having a crystal orientation that differs from (111), the closest packed plane, showed a still higher MR ratio.

Similarly, a magnetic layer including fcc-Co or bcc-Ni rather than hcp-Co or fcc-Ni of their preferential structures could improve a MR ratio of the magnetoresistive element. Introducing a crystal orientation that differs from the closest packed plane provided a still higher MR ratio.

Other experiments showed that the orientation ratio was preferably 60% or more, more preferably 80% or more.

### (Example 2-4)

A multi-layer film was formed on a Si substrate with a thermal-oxidation layer by a RF sputtering method. The multi-layer film was as follows:
Cu(100) / CuAu(500; Crystal-Structure Controlling Layer) / Fe(5ML) / Al(0.4; 200Torr, pure oxygen,1 min oxidization) /Al(0.3; 200Torr, pure oxygen, 1 min oxidization / CoFe(3) / Ru(0.7) / CoFe(3) / PtMn(30) / Ta(3)

A magnetoresistive element as shown in Fig. 6 was manufactured in the same manner as Example 1.

As the crystal-structure controlling layer, (110) oriented Cu₁₋ₓAuₓ (0<x<1) was used. A lattice strain was introduced into the fcc-Fe (100) film on the crystal-structure controlling layer by adjusting an content of Au. A MR ratio was examined on each of the magnetoresistive elements. Table 5 shows the result.

**Table 5**

| Increase in Lattice Constant (%) | MR Ratio (%) |
|---|---|
| 0 | 30 |
| 1.0 | 35 |
| 1.5 | 37 |

Introducing a lattice strain increased a MR ratio in a metastable crystal structure also.

Other experiments showed that a surface property-controlling layer stacked on the magnetic layer that was arranged on the far side with respect to the substrate also raised a MR ratio.

### Example 3

In this example, magnetoresistive elements according to the third embodiment are described.

A multi-layer film was formed on a Si substrate with a thermal-oxidation layer by a RF sputtering method. The multi-layer film was as follows:
Ta(3) / Cu(500) / Ta(3) / magnetic layer(3) /Al(0.4; 200Torr, pure oxygen,1 min oxidization) /Al(0.3; 200Torr, pure oxygen, 1 min oxidization / CoFe(3) / Ru(0.7) / CoFe(3) / PtMn(30) / Ta(3)

The magnetic layer at a thickness of 3 nm had Fe as a main component. The composition of this layer was adjusted by adding a minor component to a target or introducing a reactive gas in an atmosphere. A magnetoresistive element as shown in Fig. 6 was manufactured in the same manner in Example 1.

A MR ratio was examined on each of the magnetoresistive elements. The values of the MR ratio were standardized by taking the maximum MR ratio as 1.0. Table 6 shows the result.

**Table 6**

| Average Electron Number | FeN | FeSi | FeAl | FeCr | FeRh | FeIr | FePt |
|---|---|---|---|---|---|---|---|
| 23 | 0.5 | 0.7 | 0.6 | | | | |
| 23.5 | 0.6 | 0.9 | 0.9 | | | | |
| 24.5 | 0.8 | 0.9 | 0.9 | (0.2) | | | |
| 25.5 | 1.0 | 1.0 | 1.0 | 1.0 | | | |
| 26(Fe) | 0.5 | 0.9 | 0.9 | 0.7 | 0.7 | 0.8 | 0.8 |
| 27.5 | | | | | 0.8 | 0.9 | 0.8 |
| 28.5 | | | | | 0.8 | 1.0 | 0.9 |
| 29.5 | | | | | 1.0 | 0.9 | 0.9 |
| 30.5 | | | | | 1.0 | 0.9 | 0.9 |
| 31.5 | | | | | 0.9 | 0.8 | 1.0 |
| 32.5 | | | | | 0.8 | | 0.9 |
| 33.5 | | | | | 0.7 | | 0.8 |
| 34.5 | | | | | 0.5 | | 0.8 |
| 35.5 | | | | | | | 0.8 |
| 36 | | | | | | | 0.8 |
| 36.5 | | | | | | | 0.8 |

As shown in Table 6, two peaks were observed in the MR ratio when adding a non-magnetic element to a magnetic metal in the magnetic layer. The similar changes were observed in NiMn alloy, FeCo alloy, NiFeCo alloy and the like, or when other non-magnetic elements such as Ti, V, Mn, Ru, Os, Pd, O, C and B were added. The FeCr having an average number of 24.5 could not provide a high MR ratio since it did not include a magnetic element as a main component.

### Example 4

### (Example 4-1)

In this example, magnetoresistive elements according to the fourth embodiment are described.

A multi-layer film was formed on a Si substrate with a thermal-oxidation layer by a RF sputtering method. The multi-layer film was as follows:
Cu(500) / Excess-Element Capturing Layer (1-20) / NiFe(5) / CoFe(1.5) / Al(0.4; 600Torr, pure oxygen, 1 min oxidization) /Al(0.3; 600Torr, pure oxygen, 1 min oxidization / CoFe(3) / Ru(0.7) / CoFe(3) / PtMn(30) / Ta(3)

A magnetoresistive element as shown in Fig. 6 was manufactured in a similar manner to Example 1 except that the maximum temperature of the heat treatment was 260C°.

A MR ratio of each of the magnetoresistive elements was examined. Table 7 shows the result.

**Table 7**

| Excess-Element Capturing Layer | MR Ratio (%) |
|---|---|
| Fe | 10 |
| FeAl | 23 |
| FeSi | 25 |
| FeTi | 26 |
| FeV | 25 |
| FeCr | 26 |
| FeZr | 24 |
| FeNb | 23 |
| FeHf | 23 |
| FeTa | 23 |

The analysis by Rutherford Backscattering Spectroscopy (RBS) showed that the CoFe film was oxidized in a magnetoresistive element including a Fe film as the excess-element capturing layer. RBS also showed that a peak of oxygen was observed in the excess-element capturing layer of FeR, where R is an element having a higher compatibility with oxygen than that of Fe, for example the elements other than Fe in Table 7. In each magnetoresistive element including FeR, the content of oxygen in the excess-element capturing layers was lower than that in the tunnel (AlO) layer and higher than that in the magnetic layer.

### (Example 4-2)

A multi-layer film was formed on a Si substrate with a thermal-oxidation layer by a RF sputtering method. The multi-layer film was as follows:
Ta(3) / NiFe(5) / CoFe(1.5) /Al(0.4; 600Torr, pure oxygen,1 min oxidization) / Al(0.3; 600Torr, pure oxygen, 1 min oxidization / CoFe(3) / Ru(0.7) / CoFe(1.5) / Excess-Element Capturing Layer A(0.5-2) / CoFe(1.5) / PtMn(30) / Excess-Element Capturing Layer *B*(1-5) / Ta(3)

A magnetoresistive element as shown in Fig. 6 was manufactured in a similar manner to Example 1 except that the maximum temperature of the heat treatment was 350C°.

A MR ratio of each of the magnetoresistive element was examined. Table 8 shows the result.

**Table 8**

| Excess-Element Capturing Layer *A* | Excess-Element Capturing Layer *B* | MR ratio (%) |
|---|---|---|
| - | - | 5 |
| - | Fe | 19 |
| - | Ni | 18 |
| - | FePt | 20 |
| - | Pt | 19 |
| FePt | - | 24 |

SIMS and Auger Electron Spectroscopy showed that Mn in the PtMn film diffused and that the content of Mn in the magnetic layer (CoFe film) was higher than that in the top Ta film in the magnetoresistive element including no excess-element capturing layers.

On the other hand, in the magnetoresistive element including an excess-element capturing layer, the content of Mn in the magnetic layer was lower than that in the excess-element capturing layer. Thus, the excess-element capturing layer decreased the content of Mn in the magnetic layer. In the magnetoresistive element including the first excess-element capturing layer, the content of Mn in the magnetic layer was still lower than that in the magnetic layer of the element including the second excess-element capturing layer. It is preferable that an excess-element capturing layer is arranged between the tunnel layer and the excess-element supplying layer (antiferromagnetic layer).

## Claims

1. A magnetoresistive element comprising a substrate and a multi-layer film formed on the substrate, the multi-layer film comprising a tunnel layer and a pair of magnetic layers that sandwich the tunnel layer,
wherein a resistance value changes with a relative angle formed by magnetization directions of the pair of magnetic layers,
wherein a conductive layer is arranged between the substrate and the tunnel layer, and
wherein the conductive layer is at least one selected from:
a) a conductor composed of at least one selected from Pt, Pd, Ag, Au, C, Si, Ge, Sn and Pb;
b) an amorphous film;
c) a microcrystalline film having an average crystal diameter of 5 nm or less; and
d) a laminate including a Cu film and a non-Cu metal film.

2. The magnetoresistive element as claimed in claim 1, wherein the conductive layer is a non-magnetic film.

3. The magnetoresistive element as claimed in claim 1, wherein the conductive layer is a magnetic film.

4. The magnetoresistive element as claimed in claim 1, wherein the conductive layer is at least one selected from a), b) and c), and wherein the conductive layer has an average thickness of 10 nm or less.

5. The magnetoresistive element as claimed in claim 1, wherein the substrate is polycrystalline.

6. A magnetoresistive element comprising a substrate and a multi-layer film formed on the substrate, the multi-layer film comprising a tunnel layer and a pair of magnetic layers that sandwich the tunnel layer,
wherein a resistance value changes with a relative angle formed by magnetization directions of the pair of magnetic layers,
wherein at least one layer selected from the pair of magnetic layers comprises at least one selected from:
e) a lattice strain expressed by a lattice constant difference in a range of 0.1% to 5% with respect to a lattice constant that is calculated from the crystal structure of said at least one layer;
f) a crystal structure that is different from a preferential crystal structure at the ordinary temperature and the atmospheric pressure; and
g) a polycrystalline structure having an oriented crystal plane controlled to be other than the closest packed plane of the crystal structure of said at least one layer.

7. The magnetoresistive element as claimed in claim 6, wherein the multi-layer film further comprises a crystal-structure controlling layer, wherein the crystal-structure controlling layer is in contact with said at least one layer, and wherein at least one selected from e), f) and g) is introduced into the at least one layer by the crystal-structure controlling layer.

8. The magnetoresistive element as claimed in claim 7, wherein said at least one layer comprises at least e) and at least one element selected from Fe, Co and Ni, and wherein the crystal-structure controlling layer comprises said at least one element and an element other than Fe, Co and Ni.

9. The magnetoresistive element as claimed in claim 6, wherein the multi-layer film comprises a magnetic layer that comprises at least f) and g).

10. The magnetoresistive element as claimed in claim 9, wherein the multi-layer film comprises a magnetic layer that comprises e), f) and g).

11. A magnetoresistive element comprising a substrate and a multi-layer film formed on the substrate, the multi-layer film comprising a tunnel layer and a pair of magnetic layers that sandwich the tunnel layer,
wherein a resistance value changes with a relative angle formed by magnetization directions of the pair of magnetic layers,
wherein at least one layer selected from the pair of magnetic layers comprises at least one element selected from Fe, Co and Ni, and an element other than Fe, Co and Ni, and
wherein an average electron number of said at least one layer is in a range of 23.5 to 25.5 or 26.5 to 36, where the average electron number is a per-atom electron number calculated on the basis of the composition ratio of said at least one layer.

12. The magnetoresistive element as claimed in claim 11, wherein said element other than the magnetic element is at least one selected from Si, Al, Ti, V, Cr, Mn, Ru, Rh, Pd, Os, Ir, Pt, B, C, N and O.

13. The magnetoresistive element as claimed in claim 11, wherein the average electron number is in a range of 24.5 to 25.5.

14. The magnetoresistive element as claimed in claim 11, wherein the average electron number is in a range of 27.5 to 32.5.

15. A magnetoresistive element comprising a substrate and a multi-layer film formed on the substrate, the multi-layer film comprising a tunnel layer and a pair of magnetic layers that sandwich the tunnel layer,
wherein a resistance value changes with a relative angle formed by magnetization directions of the pair of magnetic layers,
wherein at least one layer selected from the layers in the multi-layer film that is other than the pair of magnetic layers comprises an excess element, and the excess element decreases spin polarization in at least one magnetic layer selected from the magnetic layers when the concentration of the excess element in said at least one magnetic layer increases, and
wherein the multi-layer film further comprises an excess-element capturing layer including an alloy or a compound that contains the excess element, and the content of the excess element in the excess-element capturing layer is higher than those in the magnetic layers.

16. The magnetoresistive element as claimed in claim 15, wherein the multi-layer film comprises an excess-element supplying layer, and the content of the excess-element is not lower than that in the excess-element capturing layer.

17. The magnetoresistive element as claimed in claim 16, wherein the excess-element supplying layer is the tunnel layer, and wherein the excess-element is at least one selected from B, C, N and O.

18. The magnetoresistive element as claimed in claim 17, wherein the excess-element capturing layer comprises a compound containing a metal, and the metal has a formation free-energy for a compound selected from an oxide, a nitride, a carbide and a boride that is lower than that of Fe.

19. The magnetoresistive element as claimed in claim 16, wherein the excess-element supplying layer is at least one selected from an antiferromagnetic layer and a laminated ferrimagnetic layer.

20. The magnetoresistive element as claimed in claim 19, wherein the excess-element is at least one selected from Mn and Ru.

21. The magnetoresistive element as claimed in claim 15, wherein the distance between the excess-element capturing layer and at least one selected from the pair of magnetic layers with respect to the thickness direction of the multi-layer film is 10 nm or less.
